(19) Europäisches Patentamt
European Patent Office
Office européen des brevets

(11) EP 2 862 490 B1

(12) **EUROPEAN PATENT SPECIFICATION**

(45) Date of publication and mention
of the grant of the patent:
**30.11.2016 Bulletin 2016/48**

(51) Int Cl.:
**A47L 9/12** *(2006.01)*    **A47L 9/20** *(2006.01)*
**A47L 9/19** *(2006.01)*    **A47L 9/28** *(2006.01)*

(21) Application number: **14188747.1**

(22) Date of filing: **14.10.2014**

(54) **Robot cleaner and method for sensing dust thereof**

Reinigungsroboter und Verfahren zur Messung von Staub davon

Robot nettoyeur et un procédé permettant de détecter la poussière de celui-ci

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.10.2013 KR 20130125487**

(43) Date of publication of application:
**22.04.2015 Bulletin 2015/17**

(73) Proprietor: **LG Electronics Inc.
Seoul 07336 (KR)**

(72) Inventors:
• **VENKAT,Raju C.P
Geumcheon-gu,
Seoul,153-802 (KR)**

• **ROSHY,Manayil John
Geumcheon-gu,
Seoul, 153-802 (KR)**

(74) Representative: **Ter Meer Steinmeister & Partner
Patentanwälte mbB
Nymphenburger Straße 4
80335 München (DE)**

(56) References cited:
**WO-A1-2007/074035    DE-A1-102011 050 358
JP-A- H01 153 131    JP-A- 2004 173 962
JP-A- 2008 296 221    JP-A- 2012 147 854**

EP 2 862 490 B1

## Description

BACKGROUND OF THE DISCLOSURE

### 1. Field of the Disclosure

This specification relates to a robot cleaner and a method for sensing dust thereof.

### 2. Background of the Disclosure

In general, robots have been developed for industrial use and been responsible for part of factory automation. In recent time, with further extension of robot-applied fields, medical robots, space aerial robots and the like have been developed, and household robots which can be used at ordinary homes are also under production.

A representative example of the household robot is a robot cleaner. The robot cleaner is a type of electronic device which carries out cleaning by sucking up dust or foreign materials around it while traveling (moving) a predetermined area by itself.

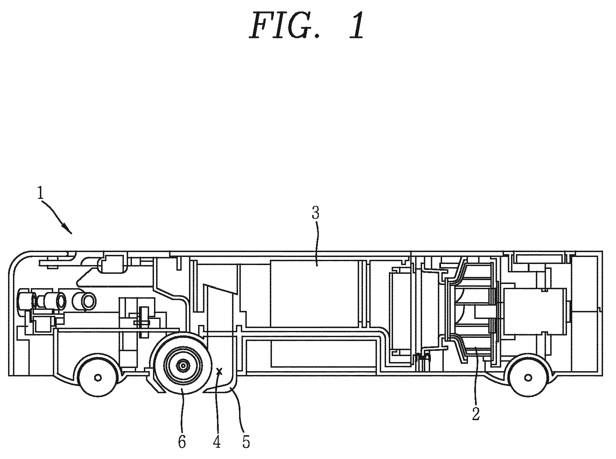

FIG. 1 is a longitudinal view briefly illustrating a typical robot cleaner.

Briefly explaining an exemplary robot cleaner 1, the robot cleaner 1 may include a suction motor 2 that is installed therein to generate a suction force, a dust container 3 that is installed at the front of the suction motor 2 to collect therein dust or dirt sucked by the suction motor 2, a suction head 5 that is located at a lower side of the robot cleaner 1 and connected to the dust container 3 through a connection pipe 4 to suck dust or foreign materials on the floor therethrough, a pair of wheels 6 that is provided to move a main body, and at least one auxiliary wheel (not illustrated) that is configured to support the robot cleaner 1 and simultaneously horizontally balance the robot cleaner 1. Here, the robot cleaner 1 may further include a driving unit (not illustrated) that is configured to provide a driving force to the wheels such that the main body of the robot cleaner 1 can be rotated or moved.

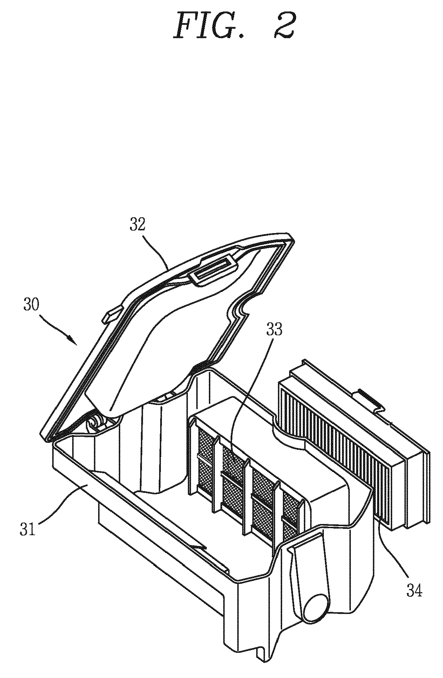

FIG. 2 is a perspective view illustrating an exemplary dust container used in a robot cleaner.

As illustrated in FIG. 2, a dust container 30 may include a main body casing 31 thereof, and a cover 32 that is provided at one side of the casing 31 to open and close the casing 31. The dust container 30 may further include a check valve (not illustrated) that is disposed at one side within the casing 31 to form an inlet through which external air containing dust is introduced, and filters 33 and 34 that are disposed at an inside or an outside of the casing 31 to filter dust before the sucked external air is discharged. The dust or dirt sucked is collected in the dust container 30 by virtue of the filters 33 and 34, and the air sucked along with the dust is discharged out of the robot cleaner 1 through the filters 33 and 34.

Based on the flow of the air which has been sucked from the outside along with dust, the filters 33 and 34 may include a first filter 33 that is located at a front side and has a mesh form, and a second filter 34 that is located at a rear side and has a wrinkled form.

The first filter 33 first filters large dust particles contained in the externally-sucked air. The air passed through the first filter 33 flows through the second filter 34, such that relatively small dust particles can be filtered, thereby being discharged out of the robot cleaner 1.

Here, as the robot cleaner 1 repetitively carries out a cleaning process with respect to a cleaning area, the filters 33 and 34 are covered with dust, which lowers a suction performance of the suction motor 2.

That is, the suction motor 2 maintains a predetermined suction force. However, the filters covered with the dust interfere with a flowing path of the externally-sucked air. Consequently, to maintain the predetermined suction force, the driving force of the suction motor 2 has to be increased. This results in an increase of energy consumption by the suction motor 2.

Therefore, a technology for overcoming such problem is in desperate need.

DE 10 2011 050358 A1 relates to a method involving using change of sensor measurement values as a measurement of a moisture content by electrical conductors, where the change is caused by moisture. The electrical conductors are arranged outside a gas flow channel and integrated in an electrical circuit in form of a sensor. The sensor is designed as a capacitor i.e. plate-type capacitor, where a measuring film acts as the capacitor. A change of a capacitance is used as the measurement of the moisture content. Self-testing of the capacitor is laterally limitingly carried out by a dielectric. An independent claim is also included for a gas flow channel.

JP H01 153131 A relates to providing a dust detecting device wherein the decrease of a sensitivity due to the adhesion of dust and a malfunction due to noises from the outside are less by providing a frequency change detector which detects the frequency of an oscillation circuit, and an output device which controls an electric blower and other apparatus by the signal from the frequency change detector. An oscillation circuit oscillates by a fixed frequency by making a condenser which is constituted of confronted electrodes and uses air as a dielectric, as the resonant element. When dust in air which is drawn by an electric blower passes between the electrodes in an air suction passage, the dust generates a change of the dielectric constant, i.e., a change of the electrostatic capacity. For this reason, the frequency of the oscillation circuit changes further, and at the output terminal of a frequency change detector, a signal in response to the frequency variation generates. For this reason, by an output device, the change can be displayed on a display device, or the revolution number of a motor of the electric blower can be controlled by using the signal. Therefore, a change of the characteristics due to the adhesion of dust is less, and a stable operation which is strong against noises from the outside, can be performed.

SUMMARY OF THE DISCLOSURE

Therefore, to obviate the related art problem, an aspect of the detailed description is to provide a robot cleaner, which is capable of sensing or removing dust on a filter, and a sensing method thereof.

The objects are solved by the features of the independent claims. According to one example, there is provided a robot cleaner including a suction motor that is installed within a main body and configured to generate a suction force, at least two conductive plates that are spaced apart from each other to form a flowing path for external air introduced by the suction force, and a calculator that is configured to measure a capacitance value between the at least two conductive plates.

In one aspect of the present disclosure, the at least two conductive plates may be in parallel to each other.

In another aspect of the present disclosure, the at least two conductive plates may be arranged to be alongside of a flowing direction of the air introduced from one side thereof.

In another aspect of the present disclosure, the calculator may sense an amount of dust within a dust container of the robot cleaner based on the capacitance value.

In another aspect of the present disclosure, the robot cleaner may further include a notification member that is configured to generate sound or light to the exterior when the capacitance value exceeds a predetermined value.

According to another example, there is provided a robot cleaner including a suction motor that is installed within a main body to generate a suction force, a porous structure that is provided with at least one through hole through which external air introduced by the suction force flows, a filter that is disposed on a flowing path of the air and configured to filter dust contained in the air, and a power supply unit that is configured to apply alternating current (AC) power to at least partial surface of the porous structure.

In one aspect of the present disclosure, the filter may be disposed on one surface of the porous structure.

Also, the filter may be disposed to be spaced apart from the porous structure.

In another aspect of the present disclosure, the porous structure may be formed in a mesh shape.

In one aspect of the present disclosure, the porous structure may have a honeycomb structure.

In one aspect of the present disclosure, the porous structure may include at least one conducting portion formed along an inner circumferential surface and/or an outer circumferential surface of the at least one through hole. Here, the power supply unit may apply n-phase AC power to the porous structure in a manner of applying power to each of n-numbered conducting portions for each phase. Here, the power supply unit may apply power having a predetermined phase difference to the conducting portions based on predetermined single-phase power, sequentially in the order of positions of the conducting portions.

According to another example, there is provided a filter assembly for a robot cleaner, the filter assembly including at least two conductive plates that are disposed by being spaced apart from each other so as to form a flowing path of external air introduced by the robot cleaner. Here, a capacitance measured between the at least two conductive plates may vary due to dust collected between the at least two conductive plates.

In one aspect of the present disclosure, the filter assembly may further include a porous structure that is provided with at least one through hole through which the air flows. The porous structure may receive alternating current (AC) power applied from the exterior to at least partial surface thereof.

According to another example, there is provided a filter assembly for a robot cleaner, the filter assembly including a porous structure that is provided with at least one conductive through hole through which external air sucked by the robot cleaner flows. At least partial surface of the through hole may receive alternating current (AC) power applied from the exterior.

In one aspect of the present disclosure, the filter assembly may further include a plurality of filters that are configured to filter dust particles in different sizes, contained in the air.

Here, one of the plurality of filters may be formed of a cotton or sponge in a pad shape. Also, one of the plurality of filters may be formed in a mesh shape. In another aspect of the present disclosure, the plurality of filters may include a filter in a shape of a folding screen to filter off dust particles contained in the air.

The present disclosure provides a dust container that is configured to collect therein dust sucked by a robot cleaner while the robot cleaner travels a cleaning area. Here, a filter assembly for the robot cleaner may be installed at one side surface of the dust container.

Also, the present disclosure provides a robot cleaner having a suction motor that is installed in a main body thereof to generate suction force. Here, a filter assembly may be provided at an end of the suction motor.

According to another example, there is provided a dust sensing method for a robot cleaner, the method including measuring a capacitance between at least two conductive plates, which are spaced apart from each other to form a flowing path of external air introduced by the robot cleaner.

In one aspect of the present disclosure, the method may further include determining whether or not the capacitance exceeds a predetermined value.

In another aspect of the present disclosure, the method may further include applying alternating current (AC) power to at least partial surface of a porous structure through which the air flows, when the capacitance exceeds the predetermined value.

In another aspect of the present disclosure, the method may further include generating sound or light when the capacitance exceeds the predetermined value.

Also, the present disclosure provides a computer-readable medium in which a computer program for executing the dust sensing method for the robot cleaner is recorded.

In a dust sensing and removing apparatus and method for a robot cleaner according to the present disclosure, dust collected on a filter can be separated, so as to prevent a suction performance of a suction motor from being lowered due to the dust collected on the filter.

Further scope of applicability of the present application will become more apparent from the detailed description given hereinafter. However, it should be understood that the detailed description and specific examples, while indicating preferred embodiments of the disclosure, are given by way of illustration only, since various changes and modifications within the scope of the disclosure will become apparent to those skilled in the art from the detailed description.

BRIEF DESCRIPTION OF THE DRAWINGS

The accompanying drawings, which are included to provide a further understanding of the disclosure and are incorporated in and constitute a part of this specification, illustrate exemplary embodiments and together with the description serve to explain the principles of the disclosure.

In the drawings:

FIG. 1 is a longitudinal view briefly illustrating a typical robot cleaner;

FIG. 2 is a perspective view illustrating an exemplary dust container used in a robot cleaner.

FIG. 3 is a conceptual view of a dust sensing apparatus included in a robot cleaner in accordance with one exemplary embodiment disclosed herein;

FIG. 4 is a view illustrating the dust sensing apparatus included in the robot cleaner in accordance with the one exemplary embodiment disclosed herein;

FIG. 5 is a view illustrating a partial configuration of a dust remover included in a robot cleaner in accordance with one exemplary embodiment disclosed herein;

FIGS. 6A and 6B are diagrams illustrating a process of removing (getting off) dust from a porous structure in accordance with one exemplary embodiment disclosed herein;

FIG. 7 is a perspective view of a filter assembly in accordance with one exemplary embodiment disclosed herein; and

FIG. 8 is a view illustrating a method for sensing and/or removing dust in a robot cleaner in accordance with one exemplary embodiment disclosed herein.

DETAILED DESCRIPTION OF THE DISCLOSURE

Dust sensing apparatus

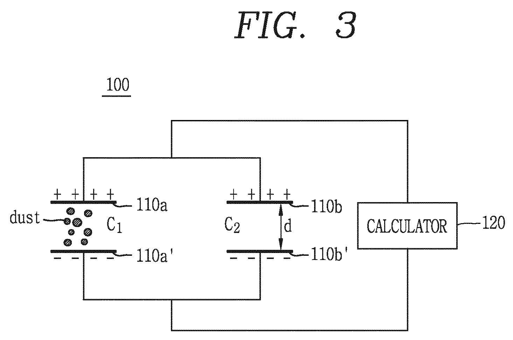

FIG. 3 is a conceptual view of a dust sensing apparatus 100 included in a robot cleaner (for example the robot cleaner 1 in Fig. 1) in accordance with one exemplary embodiment disclosed herein.

As illustrated in FIG. 3, the dust sensing apparatus 100 equipped in a robot cleaner according to one exemplary embodiment disclosed herein includes at least two conductive plates 110a and 110a', 110b and 110b' spaced apart from each other, and a calculator 120 to calculate (measure) a capacitance (value) between the plates 110a and 110a', 110b and 110b'.

A space, which is formed as the at least two conductive plates 110a and 110a', 110b and 110b' are spaced apart from each other, forms a flowing path of air sucked by the robot cleaner. Accordingly, dust particles contained in the air passed through the path may be collected (piled, stacked, accumulated, etc.) on the plates 110a and 110a', 110b and 110b'.

A capacitance value between the two plates 110a and 110a', 110b and 110b' may change according to an amount of dust collected on the plates 110a and 110a', 110b and 110b'. The changed capacitance value between the plates may be measured by the calculator 120, which may result in calculating an amount of dust collected on the at least two conductive plates and also indirectly calculating an amount of dust, which is collected on a filter or in a dust container (for example the dust container 30 in Fig. 2) located near the conductive plates.

In detail, for example, a capacitance value between the two pair of plates 110a and 110a', and 110b and 110b', which is measured by the calculator 120, for example, may be expressed by the following Equation 1, assuming that the two pair of plates are parallel plates in the same shape.

[Equation 1]

$$C = C_1 + C_2 = \varepsilon_r \varepsilon_0 \frac{A}{d}$$

where C denotes a capacitance value, $\varepsilon_0$ denotes vacuum permittivity (or vacuum dielectric constant) ($\fallingdotseq 8.854 \times 10^{-12} F/m$), $\varepsilon_r$ denotes permittivity or a relative dielectric constant of a material between the two plates, A denotes an area of one plate, and d denotes a distance between the two plates.

The capacitance value with respect to the at least two conductive plates is proportional to the permittivity ε. Here, the permittivity and the capacitance value depend on an amount of dust between the at least two plates. Therefore, an amount of dust collected (piled) between the plates and/or around the plates may be determined by the dielectric constant or the capacitance value calculated by the calculator 120. This is because the capacitance value is increased in response to an increased thickness of dust which is stacked between the at least two conductive plates.

Also, when there is a considerable amount of dust in the dust container in which externally-sucked dust is collected, dust is also stacked (accumulated) between the two plates or on the filters located near the plates, which results in the increase in the capacitance value measured by the calculator 120. Therefore, based on the capacitance value, an amount of dust collected in the dust container or an amount of dust stuck on the filters near the conductive plates can be estimated. In other words, an increase in an amount of dust collected in the dust container brings about an increase in an amount of dust which is added while the externally-sucked air passes through the dust container. This results in more dust laying on the plurality of conductive plates.

Meanwhile, to store electric charges, the at least two conductive plates 110a and 110a', 110b and 110b', for example, may be formed in a shape that two plates are disposed in parallel to each other, or in a shape that two cylinders with different radiuses from each other are coaxially arranged. However, with no limit to the shape, any shape will be available if the robot cleaner has a path for externally-sucked air.

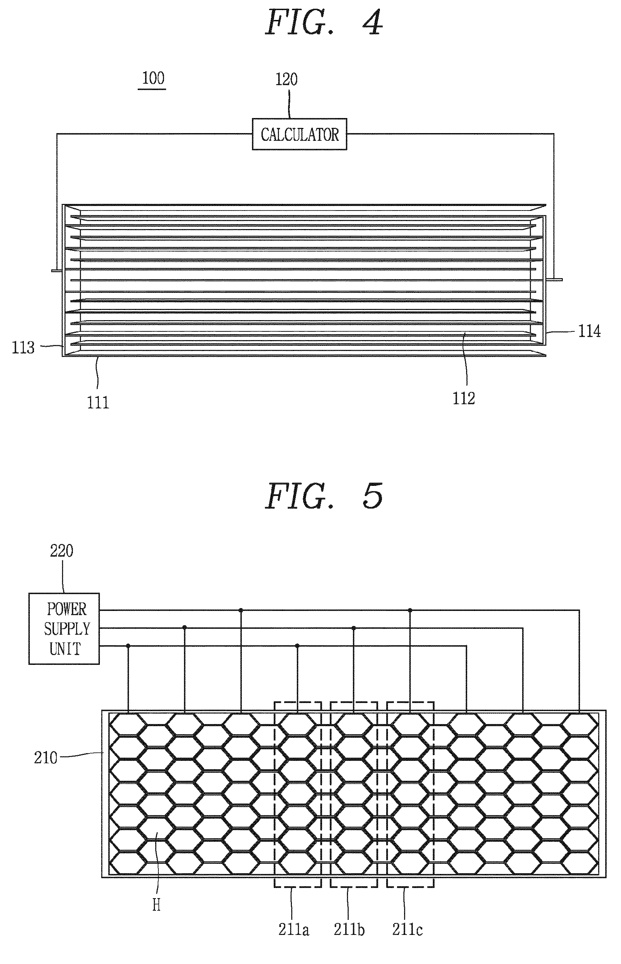

As one detailed example, the at least two plates, as illustrated in FIG. 4, may have a shape that a plurality of parallel plate capacitors are connected in parallel. That is, a plurality of first plates 111 and second plates 112 may be alternately arranged in parallel with being spaced apart from each other. A first connector 113 may connect the plurality of first plates 111 as one electrode (for example, (+) pole), and a second connector 114 may connect the plurality of second plates 112 as another electrode (for example, (-) pole).

Here, the first plates 111 and the second plates 112 may preferably be arranged to be alongside of a flowing direction of air containing dust, introduced from one side thereof, or be horizontal to the ground. This may allow dust contained in externally-introduced air to be smoothly laid on the conductive plates, without a reduction of a suction force, which is generated by the suction motor (for example 2 in Fig. 1).

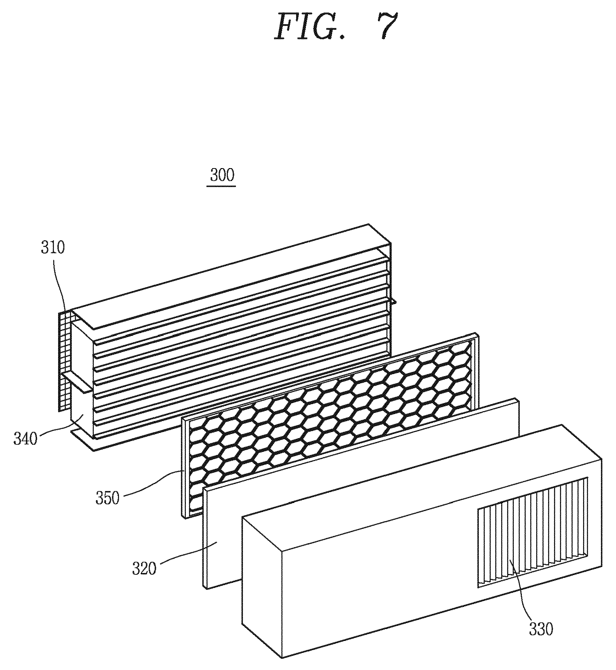

Meanwhile, the dust sensing apparatus 100 included in the robot cleaner according to the one exemplary embodiment disclosed herein may further include a dust remover which will be explained later. Accordingly, if the calculator 120 determines that a measured capacitance value has exceeded a predetermined value, the dust remover may apply Alternating Current (AC) power to at least partial surface of a porous structure 210 (or 350 in Fig. 7), so as to separate dust laid on the porous structure 210 (or 350) and/or first to third filters 310 to 330 (see Fig. 7) from them.

Here, when the calculator 120 carries out the determination as to whether the capacitance value exceeds a predetermined value k, it may repeat the calculation (measurement) of the capacitance value plural times at a predetermined time interval. Accordingly, the calculator 120 may preferably determine whether the number of calculation reaches a predetermined number of times, for example, three times, so as to decide supply or non-supply of power to the porous structure 210 using a power supply unit 220.

This may result in a more accurate determination as to whether dust collected between the at least two plates has exceeded a predetermined amount, thereby preventing an erroneous determination.

Meanwhile, the dust sensing apparatus 100 included in the robot cleaner according to the one exemplary embodiment disclosed herein may further include a notification member (not illustrated).

The notification member may be included in the calculator 120 or electrically connected to the calculator 120. When the capacitance value between the at least two conductive plates, calculated by the calculator 120, exceeds the preset value, the notification member may generate sound or light to the outside, such that a user can audibly or visibly recognize the requirements for cleaning the dust container, the conductive plates, the porous structure and/or the at least one filter.

## Dust Remover

FIG. 5 is a view illustrating a partial configuration of a dust remover included in a robot cleaner in accordance with one exemplary embodiment disclosed herein.

As illustrated in FIG. 5, a dust remover included in a robot cleaner disclosed herein includes a porous structure 210 and a power supply unit 220.

The porous structure 210 includes at least one through hole H through which external air sucked by the robot cleaner flows. The power supply unit 220 applies AC power to at least partial surface of the porous structure 210 (including at least part of an inner circumferential surface and/or outer circumferential surface of the through hole H).

In response to the AC power being applied from the power supply unit 220 to the at least partial surface of the porous structure 210, an electric field is generated. Due to the generation of the electric field, dust laid on the porous structure 210, the conductive plates and/or adjacent filters may be separated.

Among the dust laid on the porous structure 210, the conductive plates and/or the adjacent filters, electrically-charged dust particles are separated from a laid portion (i.e., a portion on which the dust particles are laid, collected, accumulated, etc.) due to an electric force caused by the AC power with positive and negative poles. Electrically-non-charged dust particles are electrically charged due to being repetitively collided with various insulators by various forces applied from the exterior, and then separated from the laid portion due to an electric force generated by the AC power applied later.

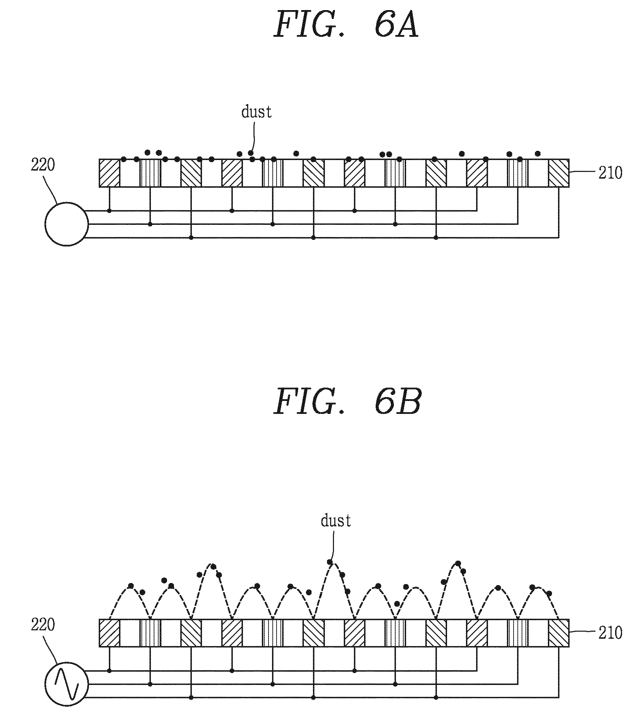

Various types of dust particles, as illustrated in FIG. 6A, which are stuck on the porous structure 210 or filters (not illustrated) adjacent to the porous structure 210 due to static electricity or the like, are separated from the porous structure 210, the conductive plates and/or the adjacent filters, by applying the AC power from the power supply unit 220 to at least partial surface of the porous structure 210, as illustrated in FIG. 6B.

Meanwhile, the porous structure 210 may be formed, for example, in a mesh shape that a plurality of through holes are arranged into a form of net, but, as illustrated in FIG. 5, may preferably have a honeycomb structure. The porous structure 210 having the honeycomb structure provides advantages in that external air sucked by the robot cleaner can flow smoothly therethrough and rigidity against an external force can be ensured.

The porous structure 210, as illustrated in FIG. 5, includes at least one conducting portion 211 a, 211b, 211c which is formed on at least partial surface thereof such that the AC power applied from the power supply unit 220 is received.

The conducting portion 211a, 211b, 211c may be formed in a predetermined shape on the at least partial surface of the porous structure 210. For example, the conducting portion 211 a, 211b, 211c may be formed along an outer circumferential surface and/or an inner circumferential surface of the plurality of through holes.

Here, when the power supply unit 220 supplies n-phase AC power, such AC power is applied to n-numbered conducting portions for each phase. Here, power with a phase difference by a predetermined phase angle is preferably supplied to each of the conducting portions 211 a, 211 b and 211 c sequentially from one side of the porous structure 210. In detail, when the power supply unit 220 supplies three-phase power, preferably, the first to third conducting portions 211a to 211c are sequentially supplied with single-phase power having a phase difference of 0°, power having a phase difference of $\pm 120°$ and power having a phase difference of $\pm 240°$, based on the single-phase power of 0° according to each position thereof. That is, the single-phase power having phase angles 0°, 120° and 240° may be applied to the first to third conducting portions 211 a to 211c, respectively.

By applying the single-phase power, which has a predetermined phase difference based on a predetermined single-phase power, to the conducting portions 211 a to 211 c sequentially according to their positions, when dust particles are separated from the porous structure 210 and the adjacent filters due to an electromagnetic force, the dust particles are separated along a direction dependent on a wavelength direction, which may result in an improvement of separation (escape, removal) efficiency of the dust particles.

Meanwhile, as aforementioned, the dust remover included in the robot cleaner disclosed herein may include a filter (not illustrated) for filtering dust contained in external air sucked by the robot cleaner.

The filter may be located on one surface of the porous structure 210, or spaced apart from the one surface of the porous structure 210 by a predetermined gap.

The filter may be provided in plurality to the dust remover. The plurality of filters may have mesh holes of different sizes, be formed of different materials, or have different shapes, to filter off dust particles of different sizes.

Such filters will be explained later in more detail.

Similarly, the dust remover included in the robot cleaner according to the one exemplary embodiment disclosed herein may further include a dust sensing apparatus. When the calculator 120 determines that a measured capacitance value has exceeded a predetermined value, the power supply unit 220 may apply AC power to the at least partial surface of the porous structure 210, thereby removing dust from the porous structure 210 and/or first to third filters 310 to 330.

Filter assembly

FIG. 7 is a perspective view of a filter assembly in accordance with one exemplary embodiment disclosed herein.

As illustrated in FIG. 7, a filter assembly 300 disclosed herein may include a plurality of conductive plates 340. A filter assembly 300 according to another exemplary embodiment may include a porous structure 350 provided with a through hole located at one side of the conductive plates 340 and formed along a flowing direction of external air sucked. Or, a filter assembly 300 according to still another exemplary embodiment may include both the plurality of conductive plates 340 and the porous structure 350.

The plurality of conductive plates 340 are spaced apart from one another to form a flowing path through which external air sucked by the robot cleaner flows. When dust contained in the external air sucked is piled in a space formed by the plurality of conductive plates 340 spaced from one another, a capacitance value of the conductive plates 340 may differ according to the amount of dust piled.

The detailed structure of the plurality of conductive plates 340 will be understood by the foregoing description, so detailed description thereof will be omitted.

Meanwhile, the porous structure 350 includes at least one through hole through which external air sucked by the robot cleaner flows. AC power is applied to at least partial surface of the porous structure 350, such that dust stuck on the porous structure 350 and/or adjacent filters can be removed therefrom by a generated electric force.

Similarly, the detailed structure of the porous structure 350 will be understood by the foregoing description, so detailed description thereof will be omitted.

Meanwhile, the filter assembly 300 according to one exemplary embodiment disclosed herein may further include a plurality of filters 310, 320 and 330 which filter dust particles of different sizes contained in the external air sucked by the robot cleaner.

In accordance with one exemplary embodiment, the first filter 310 of the plurality of filters 310, 320 and 330 may be a filter in a mesh form. The first filter 310 in the mesh form, as compared with the second and third filters 320 and 330, is preferably formed with more than 70 mesh holes (the number of mesh holes belonging to 1cm x 1cm area), such that relatively big dust particles cannot be discharged out of the dust container.

Also, the second filter 320 of the plurality of filters 310, 320 and 330 is to filter relatively small dust particles, as compared with the first filter 310. The mesh hole of the second filter 320 is preferable smaller than that of the first filter 310. For example, the second filter 320 may be cotton or sponge in a pad shape.

The third filter 330 of the plurality of filters 310, 320 and 330 is to filter dust immediately before the sucked air is discharged out of the robot cleaner. To prevent fine dust particles contained in the external air sucked by the robot cleaner from being externally redischarged, the third filter 330 may be a high efficiency particulate air (HEPA) filter in a structure like a folding screen, which seems to be wrinkled, and preferably, be a multi-HEPA filter.

The filter assembly 300 according to the one exemplary embodiment disclosed herein, as illustrated in FIG. 7, is preferably configured by employing at least one of the first filter 310, the second filter 320 and the third filter 330, or a combination thereof.

The filter assembly 300 is preferably detachable from one side surface of the dust container or the front surface of the suction motor within the robot cleaner. When the filter assembly 300 is attached in the robot cleaner, preferably, the first filter 310 is mounted toward the dust container, namely, close to the dust container, and the third filter 330 is mounted toward the suction motor, namely, close to the suction motor.

Here, the plurality of conductive plates 340 and/or the porous structure 350 included in the filter assembly 300 may be located between the first filter 310 and the second filter 320, or between the second filter 320 and the third filter 330. The first to third filters 310 to 330, the plurality of conductive plates 340 and the porous structure 350, which are all included in the filter assembly 300, may be arranged with being spaced by predetermined intervals, respectively.

Accordingly, an amount of dust piled on the components (the conductive plates 340, the porous structure 350 and the first to third filters 310 to 330) included in the filter assembly 300 or an amount of dust collected in the dust container may be estimated based on the capacitance value between the conductive plates 340 measured by the calculator 120. Also, dust piled on the components included in the filter assembly 300 may be separated by an electric force, which is generated by applying the AC current from the power supply unit 220 to a partial surface of the porous structure 350, thereby being collected in the dust container or laid down onto a predetermined space within the robot cleaner to which the dust container is mounted.

In such a manner, when the capacitance value measured with respect to the plurality of conductive plates 340 exceeds a predetermined value, the power supply unit 220 may apply power to the porous structure 350 in a periodic manner based on a predetermined time interval, or in response to an external input, thereby removing the dust piled on the conductive plates 340, the porous structure 350 or the first to third filters 310 to 330.

This may result in overcoming a problem of lowering a suction force of the suction motor, which is caused due to the dust sucked by the robot cleaner through a repetitive cleaning stroke for a cleaning area.

## Method of sensing and/or removing dust

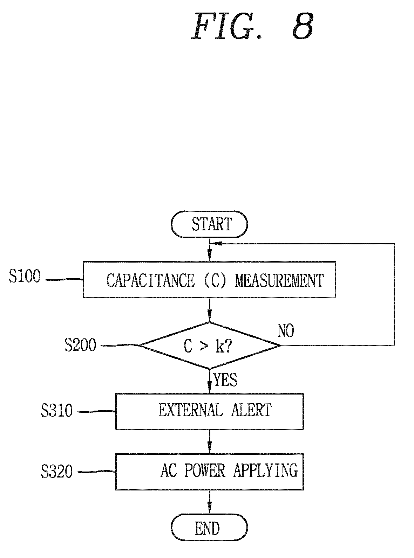

FIG. 8 is a view illustrating a method for sensing and/or removing dust in a robot cleaner in accordance with one exemplary embodiment disclosed herein.

Hereinafter, each component will be described in detail with reference to FIGS. 1 to 7, but the redundant description with the previous description will be omitted.

A method of sensing dust in a robot cleaner disclosed herein includes measuring a capacitance value between at least two conductive plates 340, which are spaced apart from each other so as to form a flowing path of external air sucked by the robot cleaner (S100).

The capacitance value may change according to an amount of dust collected between the at least two conductive plates. A calculator 120 may measure the capacitance value between the at least two conductive plates 340, thereby calculating an amount of dust piled on the at least two conductive plates 340 and also an amount of dust piled on at least one filter located adjacent to the conductive plates 340 or collected in a dust container.

The calculator 120 determines whether or not the capacitance value exceeds a predetermined value k (S200). When the capacitance value exceeds the predetermined value k, AC power is applied to at least partial surface of a porous structure 210 (S320), to separate dust piled on the porous structure 210 and/or at least one of first to third filters 310 to 330 from them.

Here, when the calculator 120 carries out the determination as to whether or not the capacitance value exceeds the predetermined value k, it may repeat the calculation (measurement) of the capacitance value plural times with a predetermined time interval. Accordingly, the calculator 120 may preferably determine whether the number of calculation reaches a predetermined number of times, for example, three times, so as to decide supply or non-supply of power to the porous structure 210 using a power supply unit 220.

This may result in a more accurate determination as to whether dust collected between the at least two plates has exceeded a predetermined amount, thereby preventing an erroneous determination.

Here, whenever the calculator 120 determines that the capacitance value has exceeded the predetermined value k, the number of times of the determination may be notified to the exterior by use of an indicator lamp or the like, or sound output through a speaker or the like.

Meanwhile, when the calculator 120 determines that the capacitance value has exceeded the predetermined value k, the power supply unit 220 applies AC power to at least partial surface of the porous structure 210 (including at least part of an inner circumferential surface and/or an outer circumferential surface of the through hole H), thereby separating the dust piled on the conductive plates 340 and/or the adjacent at least one filter.

Here, when the power supply unit 220 supplies n-phase AC power, such AC power is applied to n-numbered conducting portions for each phase. Here, power with a phase difference by a predetermined phase angle is preferably supplied to each of the conducting portions 211 a, 211 b and 211 c sequentially from one side of the porous structure 210, such that the dust can be smoothly separated from a laid portion (See FIG. 5).

Therefore, according to the method of sensing and/or removing dust of the robot cleaner disclosed herein, dust stuck on the filter can be removed or separated, thereby preventing a degradation of a suction performance of the suction motor, which is caused due to the dust piled on the filter.

Meanwhile, the calculator 120 may measure the capacitance value so as to estimate an amount of dust collected in the dust container. Therefore, the method may further include notifying a user of a full collection of dust in the dust container in an audible or visible manner by making a notification member (not illustrated) generate sound or light to the outside, when the capacitance value exceeds a predetermined value (S310).

Consequently, the user may be guided to clean the conductive plates, the porous structure and/or the at least one filter.

Computer-readable medium

The method of sensing and/or removing dust of the robot cleaner according to the one exemplary embodiment described above may be implemented as computer-readable codes and recorded in a program-recorded medium. The computer-readable media may include programming command words, data files, data structures and the like in an individual or combination form. The programming command words recorded in the computer-readable media may be those specifically designed for the present disclosure or those already known by a skilled person in a computer software field. Examples of such computer-readable media may include hard disk, floppy disk, magnetic media such as magnetic tape, CD-ROM, optical data storage element such as DVD, magnetooptical media such as a floptical disk, and hardware devices, such as ROM, RAM, flash memory and the like, which are specifically constructed to store and execute the programming command words. Examples of the programming command words may include high-level language codes executable by computers using interpreter or the like, as well as machine language made by compiler and the like. The hardware device may be configured to operate as at least one software module for executing processing according to the present disclosure, or a reverse case may also be similar.

As the present features may be embodied in several forms without departing from the characteristics thereof, it should also be understood that the above-described embodiments are not limited by any of the details of the foregoing description, unless otherwise specified, but rather should be construed broadly within its scope as defined in the appended claims, and therefore all changes and modifications that fall within the metes and bounds of the claims, or equivalents of such metes and bounds are therefore intended to be embraced by the appended claims.

Claims

1. A robot cleaner comprising a suction motor (2) that is installed within a main body and configured to generate a suction force, the robot cleaner comprising:

at least two conductive plates (111, 112) that are spaced apart from each other to form a flowing path for external air introduced by the suction force; and
a calculator (120) that is configured to measure a capacitance value between the at least two conductive plates (111, 112);
**characterized by**
a porous structure (210; 350) that is provided with at least one through hole (H) through which external air introduced by the suction force flows;
a filter (33, 34; 310, 320, 330) that is disposed on a flowing path of the air and configured to filter dust contained in the air; and
a power supply unit (220) that is configured to apply alternating current (AC) power to at least a partial surface of the porous structure (210; 350).

**2.** The robot cleaner of claim 1, wherein the at least two conductive plates (111, 112) are in parallel to each other.

**3.** The robot cleaner of claim 1 or 2, wherein the at least two conductive plates (111, 112) are arranged to be alongside of a flowing direction of the air introduced from one side thereof.

**4.** The robot cleaner of any of claims 1 to 3, wherein the calculator (120) senses an amount of dust within a dust container of the robot cleaner based on the capacitance value.

**5.** The robot cleaner of any of claims 1 to 4, further comprising a notification member that is configured to generate sound or light to the exterior when the capacitance value exceeds a predetermined value.

**6.** The robot cleaner of any of claims 1 to 5, wherein the at least two conductive plates (111, 112) have a shape that a plurality of parallel plate capacitors are connected in parallel.

**7.** The robot cleaner of claim 1, wherein the filter (33, 34; 310, 320, 330) is disposed on one surface of the porous structure (210, 350) with being spaced apart from the porous structure (210; 350).

**8.** The robot cleaner of claim 1 or 7, wherein the porous structure (210; 350) is formed in a mesh shape.

**9.** The robot cleaner of claim 8, wherein the porous structure (210; 350) has a honeycomb structure.

**10.** The robot cleaner of any one of claims 1 or 7 to 9, wherein the porous structure (210; 350) comprises at least one conducting portion (211a, 211b, 211c) formed along an inner circumferential surface and/or an outer circumferential surface of the at least one through hole (H), and wherein the power supply unit (220) applies n-phase AC power to the porous structure (210; 350) in a manner of applying power to each of n-numbered conducting portions (211 a, 211b, 211 c) for each phase.

**11.** The robot cleaner of claim 10, wherein the power supply unit (220) applies power having a predetermined phase difference to the conducting portions (211 a, 211b, 211 c) based on predetermined single-phase power, sequentially in the order of positions of the conducting portions (211 a, 211b, 211c).

**12.** A dust sensing method for a robot cleaner, the method comprising:

measuring a capacitance between at least two conductive plates (111, 112), which are spaced apart from each other to form a flowing path of external air introduced by the robot cleaner **characterized by**

applying alternating current (AC) power to at least a partial surface of a porous structure (210; 350) through which the air flows, when the capacitance exceeds the predetermined value.

**13.** The method of claim 12, further comprising determining whether or not the capacitance exceeds a predetermined value.

**14.** The method of claim 13, wherein the at least two conductive plates (111, 112) have a shape that a plurality of parallel plate capacitors are connected in parallel.

**15.** The method of any of claim 13, further comprising generating sound or light to the exterior when the capacitance exceeds the predetermined value.

**Patentansprüche**

**1.** Roboterreiniger, der einen Saugmotor (2) umfasst, der in einem Hauptkörper installiert ist und der konfiguriert ist, eine Saugkraft zu erzeugen, wobei der Roboterreiniger Folgendes umfasst:

mindestens zwei leitfähige Platten (111, 112), die voneinander beabstandet sind, um einen Strömungsweg für die Außenluft zu bilden, die durch die Saugkraft eingebracht wird; und einen Rechner (120), der konfiguriert ist, einen Kapazitätswert zwischen den mindestens zwei leitfähigen Platten (111, 112) zu messen; **gekennzeichnet durch** eine poröse Struktur (210, 350), die mit mindestens einem Durchgangsloch (H) versehen ist, **durch** das die Außenluft strömt, die **durch** die Saugkraft eingebracht wird; einen Filter (33, 34, 310, 320, 330), der in einem Strömungsweg der Luft angeordnet ist und der konfiguriert ist, den Staub zu filtern, der in der Luft enthalten ist; und eine Leistungsversorgungseinheit (220), die konfiguriert ist, eine Wechselstromleistung (AC-Leistung) an mindestens eine Teilfläche der porösen Struktur (210; 350) anzulegen.

**2.** Roboterreiniger nach Anspruch 1, wobei die mindestens zwei leitfähigen Platten (111, 112) zueinander parallel sind.

**3.** Roboterreiniger nach Anspruch 1 oder 2, wobei die mindestens zwei leitfähigen Platten (111, 112) entlang einer Strömungsrichtung der Luft, die von einer Seite davon eingebracht wird, angeordnet sind.

**4.** Roboterreiniger nach einem der Ansprüche 1 bis 3, wobei der Rechner (120) auf der Basis des Kapazitätswerts eine Staubmenge in einem Staubbehälter des Roboterreinigers erfasst.

**5.** Roboterreiniger nach einem der Ansprüche 1 bis 4, der ferner ein Anzeigeelement umfasst, das konfiguriert ist, einen Ton oder ein Licht nach außen zu erzeugen, wenn der Kapazitätswert einen vorgegebenen Wert übersteigt.

**6.** Roboterreiniger nach einem der Ansprüche 1 bis 5, wobei die mindestens zwei leitfähigen Platten (111, 112) eine Form aufweisen, derart, dass mehrere parallele Plattenkondensatoren parallel geschaltet sind.

**7.** Roboterreiniger nach Anspruch 1, wobei der Filter (33, 34, 310, 320, 330) auf einer Fläche der porösen Struktur (210, 350) angeordnet ist, wobei er von der porösen Struktur (210, 350) beabstandet ist.

**8.** Roboterreiniger nach Anspruch 1 oder 7, wobei die poröse Struktur (210, 350) in einer Maschenform ausgebildet ist.

**9.** Roboterreiniger nach Anspruch 8, wobei die poröse Struktur (210, 350) eine Wabenstruktur aufweist.

**10.** Roboterreiniger nach einem der Ansprüche 1 oder 7 bis 9, wobei die poröse Struktur (210, 350) mindestens einen leitenden Abschnitt (211a, 211b, 211c) umfasst, der entlang einer Innenumfangsfläche und/oder entlang einer Außenumfangsfläche des mindestens einen Durchgangslochs (H) ausgebildet ist, und wobei die Leistungsversorgungseinheit (220) eine n-Phasen-Wechselstromleistung an die poröse Struktur (210, 350) anlegt, indem sie für jede Phase eine Leistung an jeden der in der Anzahl n vorhandenen leitenden Abschnitte (211 a, 211b, 211 c) anlegt.

**11.** Roboterreiniger nach Anspruch 10, wobei die Leistungsversorgungseinheit (220) auf der Basis einer vorgegebenen Einzelphasenleistung aufeinanderfolgend in der Reihenfolge der Positionen der leitenden Abschnitte (211a, 211b, 211 c) eine Leistung an die leitenden Abschnitte (211 a, 211b, 211c) anlegt, die einen vorgegebenen Phasenunterschied aufweist.

**12.** Stauberfassungsverfahren für einen Roboterreiniger, wobei das Verfahren Folgendes umfasst:

Messen einer Kapazität zwischen mindestens zwei leitfähigen Platten (111, 112), die voneinander beanstandet sind, um einen Strömungsweg der Außenluft zu bilden, die durch den Roboterreiniger eingebracht wird, **gekennzeichnet durch** Anlegen einer Wechselstromleistung (AC-Leistung) an mindestens eine Teilfläche einer porösen Struktur (210, 350), **durch** die die Luft strömt, wenn die Kapazität den vorgegebenen Wert übersteigt.

**13.** Verfahren nach Anspruch 12, das ferner das Bestimmen, ob die Kapazität einen vorgegebenen Wert übersteigt oder nicht, umfasst.

**14.** Verfahren nach Anspruch 13, wobei die mindestens zwei leitfähigen Platten (111, 112) eine Form aufweisen, derart, dass mehrere parallele Plattenkondensatoren parallel geschaltet sind.

**15.** Verfahren nach Anspruch 13, das ferner das Erzeugen eines Tons oder eines Lichts nach außen, wenn die Kapazität den vorgegebenen Wert übersteigt, umfasst.

**Revendications**

**1.** Robot nettoyeur comprenant un moteur d'aspiration (2) qui est installé à l'intérieur d'un corps principal et configuré pour générer une force d'aspiration, le robot nettoyeur comprenant :

au moins deux plaques conductrices (111, 112) qui sont espacées l'une l'autre pour former un trajet d'écoulement de l'air externe introduit par la force d'aspiration ; et un calculateur (120) qui est configuré pour mesurer une valeur de capacitance entre au moins deux plaques conductrices (111, 112), **caractérisé par** une structure poreuse (210 ; 350) qui est pourvue d'au moins un alésage traversant (H) à travers lequel l'air externe introduit par la force d'aspiration s'écoule ; un filtre (33, 34 ; 310, 320, 330) qui est disposé sur un trajet d'écoulement de l'air et configuré pour filtrer la poussière contenue dans l'air ; et une unité d'alimentation électrique (220) qui est configuré pour appliquer un courant alternatif (CA) à au moins une surface partielle de la structure poreuse (210 ; 350).

**2.** Robot nettoyeur selon la revendication 1, dans lequel les au moins deux plaques conductrices (111, 112) sont parallèles l'une à l'autre.

**3.** Robot nettoyeur selon la revendication 1 ou 2, dans lequel les au moins deux plaques conductrices (111, 112) sont agencées afin d'être le long d'une direction d'écoulement de l'air introduit à partir d'un côté de ces dernières.

4. Robot nettoyeur selon une quelconque des revendications 1 à 3, dans lequel le calculateur (120) détecte une quantité de poussière à l'intérieur d'un conteneur de poussière du robot nettoyeur sur la base de la valeur de capacitance.

5. Robot nettoyeur selon une quelconque des revendications 1 à 4, comprenant en outre un élément de notification qui est configuré pour générer un son ou une lumière vers l'extérieur lorsque la valeur de capacitance excède une valeur prédéterminée.

6. Robot nettoyeur selon une quelconque des revendications 1 à 5, dans lequel les au moins deux plaques conductrices (111, 112) ont une forme telle qu'une pluralité de condensateurs de plaques parallèles sont raccordés en parallèle.

7. Robot nettoyeur selon la revendication 1, dans lequel le filtre (33, 34 ; 310, 320, 330) est disposée sur une surface de la structure poreuse (210, 350) tout en étant espacée de la structure poreuse (210, 350).

8. Robot nettoyeur selon la revendication 1 ou 7, dans lequel la structure poreuse (210, 350) est formée en forme de maille.

9. Robot nettoyeur selon la revendication 8, dans lequel la structure poreuse (210, 350) a une structure en nid d'abeille.

10. Robot nettoyeur selon une quelconque des revendications 1 ou 7 à 9, dans lequel la structure poreuse (210 ; 350) comprend au moins une portion conductrice (211a, 211b, 211c) formée le long d'une surface circonférentielle interne et/ou une surface circonférentielle externe d'au moins un alésage traversant (H) et
dans lequel l'unité d'alimentation électrique (220) alimente une puissance CA n-phase à la structure poreuse (210 ; 350) à la manière de l'application de puissance à chacune de portions conductrices de numéro n (211a, 211b, 211c) pour chaque phase.

11. Robot nettoyeur selon la revendication 10, dans lequel l'unité d'alimentation électrique (220) applique une puissance ayant une différence de phase prédéterminée aux portions conductrices (211a, 211b, 211c) sur la base d'une puissance monophasée prédéterminée, séquentiellement dans l'ordre des positions des portions conductrices (211a, 211b, 211c).

12. Procédé de détection de poussière pour un robot nettoyeur, le procédé comprenant de :

mesurer une capacitance entre au moins deux plaques conductrices (111, 112), qui sont espacées l'une l'autre pour former un trajet d'écoulement de l'air externe introduit par la force d'aspiration ;
**caractérisé par**
appliquer un courant alternatif (CA) à au moins une surface partielle de la structure poreuse (210 ; 350) à travers laquelle l'air s'écoule, lorsque la capacitance que excède la valeur prédéterminée.

13. Procédé selon la revendication 12, comprenant en outre de déterminer si ou non la capacitance excède une valeur prédéterminée.

14. Procédé selon la revendication 13, dans lequel les au moins deux plaques conductrices (111, 112) ont une forme telle qu'une pluralité de condensateurs de plaques parallèles sont raccordés en parallèle.

15. Procédé selon la revendication 13, comprenant en outre de générer un son ou une lumière vers l'extérieur lorsque la capacitance excède une valeur prédéterminée.

FIG. 1

# FIG. 2

# FIG. 3

# FIG. 4

# FIG. 5

## FIG. 6A

dust

220

210

## FIG. 6B

dust

220

210

# FIG. 7

# FIG. 8

```
                    ┌─────────┐
                    │  START  │
                    └────┬────┘
                         │
                         ▼
S100 ──┌──────────────────────────────────┐
       │  CAPACITANCE (C) MEASUREMENT      │
       └──────────────────┬───────────────┘
                          │
                          ▼           NO
S200 ──        ◇ C > k? ◇ ──────────┐
                          │
                          │ YES
                          ▼
S310 ──┌──────────────────────────────────┐
       │        EXTERNAL  ALERT            │
       └──────────────────┬───────────────┘
                          │
                          ▼
S320 ──┌──────────────────────────────────┐
       │       AC POWER APPLYING           │
       └──────────────────┬───────────────┘
                          │
                          ▼
                    ┌─────────┐
                    │   END   │
                    └─────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102011050358 A1
- JP H01153131 A